(19)

Europäisches
Patentamt
European
Patent Office
Office européen
des brevets

(11) **EP 3 993 075 A1**

(12) **EUROPEAN PATENT APPLICATION**

(43) Date of publication:
**04.05.2022 Bulletin 2022/18**

(21) Application number: **21214316.8**

(22) Date of filing: **25.08.2015**

(51) International Patent Classification (IPC):
*H01L 51/00* (2006.01)  *C23C 14/04* (2006.01)
*C23C 14/12* (2006.01)  *C23C 16/04* (2006.01)
*C23F 1/02* (2006.01)

(52) Cooperative Patent Classification (CPC):
**C23C 14/12; C23C 14/042; C23C 16/042;**
**C23F 1/02; H01L 51/0011**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **24.04.2015  KR 20150058346**
**30.04.2015  KR 20150062137**

(62) Document number(s) of the earlier application(s) in
accordance with Art. 76 EPC:
**15890003.5 / 3 288 097**

(71) Applicant: **LG INNOTEK CO. LTD**
**Jung-gu**
**Seoul**
**04637 (KR)**

(72) Inventors:
• **ROH, Geon Ho**
**100-714 SEOUL (KR)**
• **CHO, Su Hyeon**
**100-714 SEOUL (KR)**
• **HWANG, Joo Hyun**
**100-714 SEOUL (KR)**

• **KIM, Nam Ho**
**100-714 SEOUL (KR)**
• **LEE, Sang Beum**
**100-714 SEOUL (KR)**
• **LIM, Jeong Ryong**
**100-714 SEOUL (KR)**
• **HAN, Tae Hoon**
**100-714 SEOUL (KR)**
• **MOON, Byung Youl**
**100-714 SEOUL (KR)**
• **PARK, Jae Seok**
**100-714 SEOUL (KR)**
• **SON, Hyo Won**
**100-714 SEOUL (KR)**

(74) Representative: **Novagraaf Technologies**
**Bâtiment O2**
**2, rue Sarah Bernhardt**
**CS90017**
**92665 Asnières-sur-Seine Cedex (FR)**

Remarks:
This application was filed on 14-12-2021 as a
divisional application to the application mentioned
under INID code 62.

(54) **DEPOSITION MASK**

(57)      Embodiments of the present invention relate to
a mask structure applicable to a deposition process for
an organic light-emitting device, etc., and allow provision
of a deposition mask comprising: a first surface and a
second surface which are orthogonal in the thickness
direction of a metal plate and face each other; and mul-
tiple unit holes which have a first surface hole and a sec-
ond surface hole which pass through the first surface and
the second surface and are in connection with each other,
wherein the size variation of the first surface hole or the
second surface hole between neighboring unit holes is
controlled within 2%-10% on the basis of the size varia-
tion between optional unit holes, or the center of the first
surface hole and the center of the second surface hole
are arranged at a location where the centers do not co-
incide with each other on the basis of the surface of the
first surface.

【Fig. 2】

**Description**

[Technical Field]

The embodiments of the present invention relate to a metal plate applicable to a deposition process for an organic light emitting device and a mask structure using the same.

[Background Art]

In the manufacturing process of an organic electroluminescence (EL) color display including an organic EL light emitting device, an organic layer including an organic material is formed through a vacuum deposition process including an organic material. In this case, there has been used a deposition mask having a plurality of holes used to permeate a material in match with the pattern of the organic layer. In general, the holes constituting the deposition mask may be formed through a photo-etching scheme of performing an etching process after exposing the pattern by applying a photoresist film on metal thin film or through an electro-forming scheme of performing a delamination process after electroplating for a glass disc in a desired pattern.

A conventional deposition mask is realized in the form of a typical metal mask. However, a scheme for the typical metal mask is concentrated on exactly realizing only open areas for deposition. However, through the above scheme, deposition efficiency is not improved and an effect of reducing a dead space, which is not subject to deposition, is not greatly produced.

[Disclosure]

[Technical Problem]

Embodiments of the present invention are made to solve the above problem and can provide a deposition mask having a structure capable of preventing stain and Moire of an organic light emitting device (OLED) panel after adjusting the uniformity between unit deposition pores adjacent to each other and performing a deposition process.

In addition, another embodiment of the present invention can provide a deposition mask capable of improving the deposition efficiency by arranging a first surface hole and a second surface hole constituting a unit hole for deposition such that the center of the first surface hole is mismatched from the center of the second surface, and capable of minimizing a dead space, which is not subject to a deposition process, in deposition, thereby enhancing the uniformity of the deposition even in a large-area deposition target.

In particular, a metal substrate can be provided to minimize the twist occurring when the metal plate to be fabricated to the deposition mask is etched. Further, the deposition mask including a plurality of unit holes for deposition can be realized based on the metal substrate. In addition, the deposition efficiency may be increased by controlling roughness of the unit holes of the deposition mask.

[Technical Solution]

In order to accomplish the problems, according the embodiment of the present invention, there may be provided a deposition mask including a metal plate having a thickness. The metal plate may include a first surface and a second surface, which are perpendicular to a direction of the thickness and opposite to each other, and a plurality of unit holes having a first surface hole and a second surface hole formed through the first surface and the second surface, respectively, to connect with each other. A size difference in the first surface hole or the second surface hole between unit holes adjacent to each other may be within 10% of a size difference between random unit holes.

In addition, according to another embodiment of the present invention, there may be provided a deposition mask including a metal plate having a thickness (t). The metal plate may include a first surface and a second surface, which are perpendicular to a direction of the thickness and opposite to each other, and a plurality of unit holes having a first surface hole and a second surface hole formed through the first surface and the second surface, respectively, to connect each other. The metal plate may include at least one unit hole in which the center of the first surface hole is mismatched from the center of the second surface hole with respect to a surface of the first surface.

In addition, according to still another embodiment of the present invention, there may be provided a metal substrate including a base metal plate having a thickness. The base metal plate includes a first surface and a second surface perpendicular to the thickness direction and opposite to each other. A sample substrate having the size of 30mm*180mm (width * length) is extracted from a specific point of the base metal plate and an etching process is performed with respect to the inner part of the sample substrate except for 10 mm (part 220) inward from both ends of the sample substrate 200 such that an etching area is formed with the thickness corresponding to 2/3 to 1/2 of the thickness of the sample substrate. Thereafter, when the sample substrate is mounted on the horizontal target surface, the twist index (Hr) of the sample substrate satisfies the following relation.

$$\{Equation\ 1\}$$
$$Hr = \{(H1 - Ha)^2 + (H2 - Ha)^2 + (H3 - Ha)^2 + (H4 - Ha)^2\}^{1/2}$$

$$\{Equation\ 2\}$$
$$Ha = (H1 + H2 + H3 + H4)/4$$

(Ha refers to the average of distances H1, H2, H3, and H4 from a horizontal target surface to four corners of the etched sample substrate.) In addition, there may be provided a deposition mask including a plurality of unit holes for deposition by using a metal plate satisfying the above-described twist index (Hr).

[Advantageous Effects]

According to the embodiment of the present invention, stain and Moire of the OLED panel can be prevented after adjusting the uniformity between unit holes for deposition adjacent to each other and performing the deposition process

In addition, according to another embodiment of the present invention, the deposition efficiency can be improved by arranging a first surface hole and a second surface hole constituting a unit hole for deposition such that the center of the first surface hole is mismatched from the center of the second surface. In addition, a dead space which is not subject to a deposition process can be minimized in deposition, thereby enhancing the uniformity of the deposition even in a large-area deposition target.

In addition, according to the embodiment of the present invention, the metal substrate can be provided to minimize the twist occurring when the metal plate to be fabricated to a deposition mask is etched.

In particular, when the deposition mask including a plurality of unit holes for deposition is realized based on the metal substrate according to the embodiment of the present invention, the twist of the deposition mask can be remarkably reduced, so that the deposition uniformity and the deposition efficiency may be maximized.

Further, according to another embodiment of the present invention, when the deposition mask including a plurality of unit holes for deposition can be realized based on the metal substrate according to the embodiment of the present invention, the deposition efficiency and the deposition uniformity can be increased by controlling the surface roughness of the inner circumferential surface of the unit hole.

[Description of Drawings]

FIG. 1 is a schematic view illustrating the operating state of a deposition mask according to an embodiment of the present invention. FIG. 2 is a cross-sectional view schematically illustrating the subject matter of the deposition mask according to an embodiment of the present invention.

FIG. 3 is a plan view illustrating a second surface of the deposition mask in the structure of FIG. 2 according to an embodiment of the present invention.

FIG. 4 is a plan view illustrating a first surface of the deposition mask in the structure of FIG. 2 according to an embodiment of the present invention.

FIG. 5 is a plan view illustrating a first surface hole and a second surface hole when viewed from the second surface in the structure of FIG. 4.

FIG. 6 is a schematic view illustrating a manner of arranging the central axis of the first surface hole and the central axis of the second surface hole according to an embodiment of the present invention.

FIG. 7 is a schematic view illustrating a manner of determining the center of the first surface hole of FIG. 6.

FIG. 8 is a cross-sectional view schematically illustrating the deposition mask including a plurality of unit holes of FIG. 2, according to a third embodiment of the present invention.

FIG. 9 is a cross-sectional view schematically illustrating the deposition mask according to another embodiment of the present invention.

FIG. 10 is a cross-sectional view schematically illustrating a unit hole in which the first surface hole and the second surface hole of FIG. 9 connect with each other.

FIG. 11 is a partial view illustrating a portion of the first surface in which the first surface hole of FIG. 10 is realized.

FIG. 12 is a view illustrating an arithmetic average roughness (Ra). FIG. 13 illustrates an image to explain Ten Point Height of Irregularities (Rz).

FIGS. 14 to 16 are views illustrating the measurement and the definition of the straightness according to the present invention.

FIGS. 17 and 18 are schematic views illustrating the feature of the metal substrate according to an embodiment of the present invention.

[Best Mode]

[Mode for Invention]

Hereinafter, the configuration and the operation according to the present invention will be described in detail with reference to accompanying drawings. In the following description made with reference to accompanying drawings, the same elements will be assigned with the same reference numerals regardless of a figure number, and the repetition in the description on the same elements will be omitted. The terms "first" and "second" are used to explain various elements. The elements may be not defined by the terms. The terms are used only to distinguish from one element from another element.

1. First Embodiment

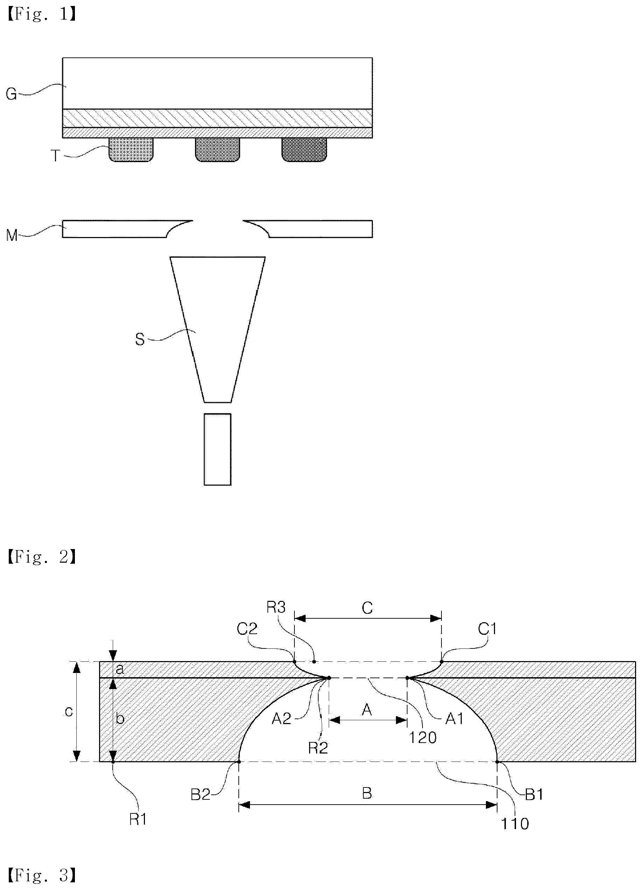

FIG. 1 is a schematic view illustrating the operating state of a deposition mask according to an embodiment of the present invention. FIG. 2 is a cross-sectional view schematically illustrating the subject matter of the deposition mask according to an embodiment of the present invention.

Referring to FIGS. 1 and 2, the deposition mask according to an embodiment of the present invention, which serves as a mask structure realized to form an organic layer of an organic light emitting diode (OLED), may be to realize a deposition target T on a base material G such as a deposition source S glass. In this case, the deposition mask (M) 100 is realized in a structure having a plurality of unit holes. The unit holes may be realized in which a first surface hole 110 and a second surface hole 130, which have mutually different widths, connect with each other.

In detail, similarly to the structure of FIG. 2, the deposition mask 100 according to an embodiment of the present invention includes a metal plate having a predetermined thickness and including a first surface and a second surface opposite to each other while being perpendicular to a thickness direction. The deposition mask 100 includes a plurality of unit holes having a first surface hole 110 and a second surface hole 1320 connecting with each other while passing through the first surface and the second surface. In this case, the first surface hole 110 and the second surface hole 130 share a boundary part 120 through which the first and second surface holes 110 and 130 connect with each other. A plurality of unit holes are provided. In particular, according to an embodiment of the present invention, the size difference in the first surface or the second surface hole between unit holes adjacent to each other may be realized within 10% of the size difference between random unit holes. In other words, the size difference in the first surface hole or the second surface hole between the adjacent unit holes may have a larger value or a smaller value within 1% to 10% of the size of the first surface hole or the second surface hole of one unit hole at a specific point. The size difference between the adjacent unit holes may be, more preferably, realized in the range of 2% to 8%.

In this case, the size difference between unit holes adjacent to each other may be compared based on a diameter difference between the first surface holes adjacent to each other or the second surface holes adjacent to each other.

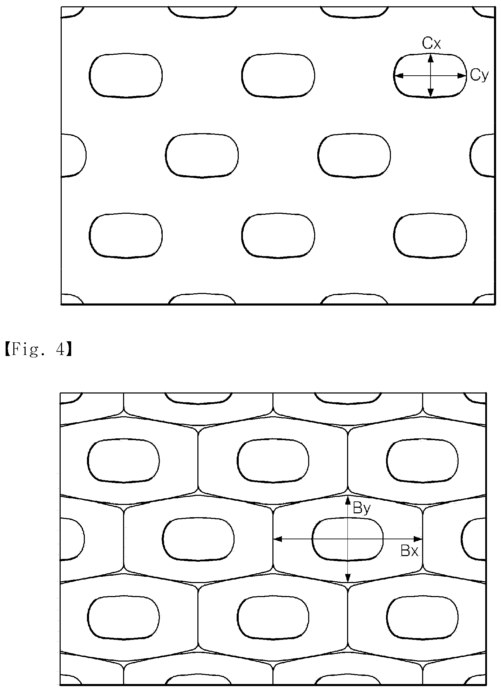

In other words, FIG. 3 is a plan view illustrating the second surface of the deposition mask in the structure of FIG. 2 according to an embodiment of the present invention. FIG. 4 is a plan view illustrating the first surface of the deposition mask in the structure of FIG. 2 according to an embodiment of the present invention.

Referring to FIG. 3, when a vertical-direction diameter Cy and a horizontal-direction diameter Cx of a specific entity (hereinafter, referred to "a reference hole") among second surface holes of a plurality of unit holes realized in the second surface are measured, the difference in the vertical-direction diameter Cy between holes (six holes in total as illustrated in drawing) adjacent to the reference hole is realized within 10%.

In addition, the difference in the horizontal-direction diameter Cx between the reference hole and another hole adjacent to the reference hole may be realized to less than 10%. In other words, when the size difference between holes adjacent to one reference hole is realized to less than 10%, the deposition uniformity may be ensured. If the size difference between the reference hole and the adjacent holes is within 10% for the purpose of improving deposition uniformity, the difference in the vertical-direction diameter Cx between the reference hole and another adjacent hole or the deviation in the horizontal-direction diameter Cx between the reference hole and the another adjacent hole may be preferably in the range of 1% to 10% or the range of 2% to 8%, the deposition uniformity may be enhanced. In contrast, when all holes are realized in equal size, Moire may occur with higher probability in an OLED panel subject to the deposition process. When the size difference between mutually adjacent holes exceeds 10% of the size of the reference hole, the probability of causing color stain in the OLED panel subject to the deposition mask is increased.

The above criterion is identically applied even to the first surface hole realized in the first surface of the metal plate of FIG. 4. The difference in a vertical-direction diameter By and a horizontal-direction diameter Bx between a first hole, which serves as a specific reference hole, and an adjacent hole may be realized within 10%. Further, more preferably, the size difference may be realized with a larger value or a smaller value in the range of 1% to 10%. The size difference between the reference hole and the adjacent hole may be, more preferably, realized in the range of 2% to 8%.

In addition, according to an embodiment of the present invention, the size difference between the reference hole and an adjacent hole may be realized within $\pm 3$ $\mu$m.

For example, in FIG. 3, the vertical direction diameter Cy of the reference hole may be 36 $\mu$m and the diameter of the adjacent hole may be 33 $\mu$m or 39 $\mu$m, which represents the difference of $\pm 3$ $\mu$m. In this case, the diameter deviation percentage between the reference hole and the adjacent hole becomes 8.3%, that is, the size difference between the reference hole and the adjacent hole is realized within 10% of the size of the reference hole, thereby improving the deposition efficiency.

For another example, in FIG. 3, the horizontal diameter Cx of the reference hole is 125 $\mu$m and the diameter of the adjacent hole may be in the range of 122 $\mu$m or 128 $\mu$m. In this case, the deviation percentage becomes 2.4 %. Accordingly, the size difference between the adjacent hole and the reference hole is realized within 10% the size of the reference hole, thereby improving the deposition efficiency.

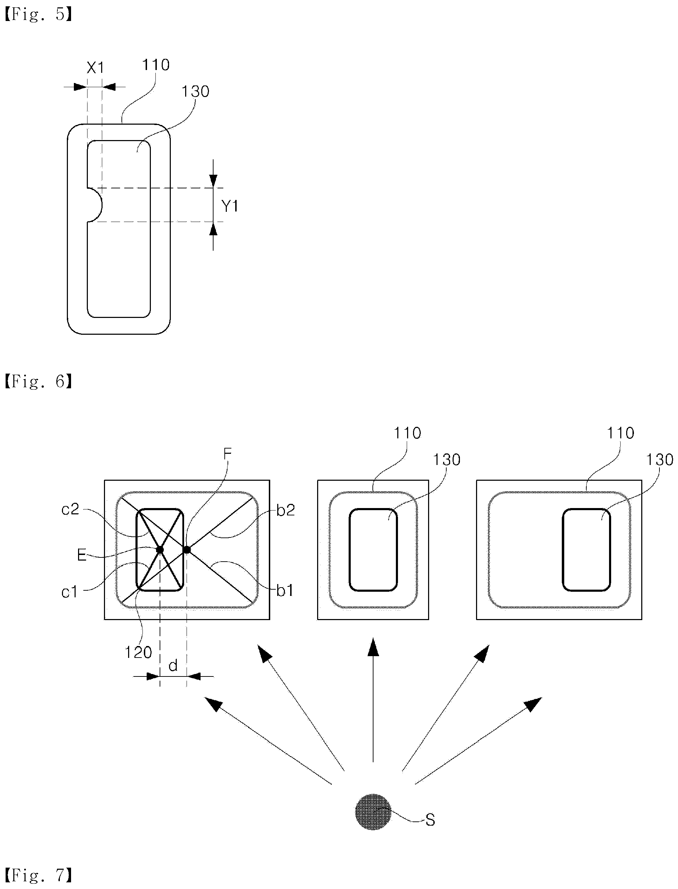

FIG. 5 is a plan view illustrating the first surface hole 110 and the second surface hole 130 of the structure of FIG. 4 when viewed from the second surface. When the size difference between the above-described holes is calculated based on a specific protrusion of an outer circumferential surface of the hole, the width Y1 of a protrusion protruding toward the center of the second surface hole from the outer circumferential surface of the second surface hole or the height X1 of the protrusion is preferably realized to have the maximum value of less than 20 $\mu$m. The protrusion corresponds to the defective structure essentially occurring in the deposition process. According to an embodiment of the present invention, the protrusion is realized to have the size of 20 $\mu$m, thereby ensuring the deposition uniformity. In particular, according to an embodiment of the present invention, the above-described protrusion may be realized to have the size of 11 $\mu$m or less, further, 6 $\mu$m or less.

2. Second embodiment

Hereinafter, the structure of a deposition mask according to another embodiment of the present invention will be described with reference to FIGS. 1 to 5.

FIG. 6 is a schematic view illustrating a manner of arranging the central axis of the first surface hole and the central axis of the second surface hole according to an embodiment of the present invention.

The structure according to the second_embodiment may have the feature of the first embodiment. However, in the following description, the structure having the feature of the second embodiment is independently realized for the illustrative purpose.

According to the second embodiment, as illustrated in FIGS. 2 and 6, the deposition mask has a structure that includes a metal plate having a specific thickness and a plurality of unit holes having a first surface hole and a second surface hole formed through the first surface and the second surface of the metal plate, respectively, and connecting with each other. In this regard, the deposition mask has the same structure as that of the first embodiment.

In this case, the deposition mask has a feature in that the center F of the first surface hole 110 and the center E of the second surface hole 130 may be mismatched from each other when viewed with respect to the surface of the first surface. In other words, the center of the first surface hole and the center of the second surface hole are mismatched from each other such that the center of the first surface hole and the center of the second surface hole are not coincident with each other.

When the center of the first surface hole and the center of the second surface hole are mismatched from each other such that the center of the first surface hole and the center of the second surface hole are not coincident with each other as described in the second embodiment of the present invention, a superior advantage is obtained since the higher deposition uniformity is ensured.

As illustrated in FIG. 6, when taking into consideration the radiation angle from a deposition source (S) spaced apart from the deposition mask having a plurality of unit holes, the deposition material of the deposition source (S) is applied to the unit holes at mutually different positions. Accordingly, the deposition materials may not be uniformly transferred. Therefore, according to the present invention, in order to improve the deposition uniformity, each hole is realized such that the central axis of the second surface hole is mismatched from each other the central axis of the first surface hole. Accordingly, even in the deposition process performed throughout the entire surface of a substrate having a larger area, the deposition material may be uniformly transferred, thereby improving the deposition uniformity. Further, even when it is necessary to increase the deposition thickness, the structure allows the deposition thickness to efficiently adjust throughout the local area or the entire area of a deposition target.

The arrangement structure, in which the center of the first surface hole and the center of the second surface hole are not coincident with each other, may a structure in which a virtual perpendicular line passes through only one of two of the center of the first surface and the center of the second center when the a virtual vertical line perpendicular to the first surface or the second surface of the metal plate may be drawn on the center of the first surface hole or the center of the second surface. Accordingly, the central axis of the first surface hole or the central axis of the second surface may be mismatched from each other.

In addition, the center of the first surface hole and the center of the second surface hole defined according to the second embodiment of the present invention may refer to the centers of circles or ovals when the outer circumferential surface of the first surface hole and the second surface hole are the circles or the oval. The centers of the first and second surfaces may refer to the gravity of weight when the outer circumferential surfaces of the first surface hole and the second surface hole represent polygonal shapes.

Alternatively, as illustrated in the structure of FIG. 6, even in the case of a plan hole having a curvature structure rounded at a corner part thereof, when the center of gravity is determined, the center of gravity serves as the center of the plan hole.

Further, regarding the center of the plan hole in the case that a curved corner (according to an embodiment of the present invention, when there are pointed portions, the pointed portions serve as corners, and when there are edge parts having curvatures, parts having a curvature smaller than the curvature of a surrounding serves as corners) is realized at an outer portion of the plan hole, when n corners having curvatures are provided, and when n is an even number, lines are drawn through facing corners and the number of lines becomes K. In this case, if the number K of the lines is three or two, a circle may be drawn around a point at which three lines or two lines meet each other. The center of the circle may serve as the center of the plan hole.

Alternatively, if the number (n) of corners is an odd number, lines are drawn through corners and sides facing the corners. On the assumption that the number of lines is "k", lines are drawn until the number (k) of the lines is 3 or 2. Then, a point at which the lines meet each other serves as the center of the plan hole.

For example, FIG. 7 is a view illustrating a manner of determining the center F of the first surface hole 110 of FIG. 6, in which the number of rounded corners is 4 (even number) in total. Accordingly, when lines b1 and b2 are drawn from one central point of a curvature to another corner positioned in the direction of facing the another corner, the number (K) of lines is two, and a point at which two points meet each other serves as the center F of the first surface hole.

In addition, the center E of the second surface hole 130 is determined in the same manner, and unit holes are realized such that the centers E and F are mismatched from each other. In particular, as illustrated in FIG. 6, the distance d between the center F of the first surface hole and the center E of the second surface hole may be realized to be at least 90% of the length A of the diameter of the second surface hole, that is 0.9A.

Further, the distance d between the center F of the first surface hole and the center E of the second surface hole may be realized in this range, preferably, 50% or less of the length A of the diameter of the second surface hole, more preferably, in the range of 0.1% to 10%, the range of 0.2% to 8%, or the range of 0.2 % or 5%. When the mismatching degree of the distance between central axes is realized to at least 90% of the length A of the diameter of the second surface hole, the uniformity of the deposition efficiency may be more increased.

In other words, when the length A of the diameter of the second surface hole is 125 $\mu$m, the distance (d) between the center (F) of the first surface hole and the center (E) of the second surface hole may be realized to be at least 112.5 $\mu$m.

As described above, in the deposition process which employs the deposition mask, since deposition sources and all unit holes of the mask are not provided at a lower portion in a vertical direction. Accordingly, an angle exceeding a specific angle and a bottom height are required for each unit hole to improve the deposition uniformity for the OLED.

In this case, when the deposition mask according to the embodiment of the present invention is employed, the first surface hole and the second surface hole are arranged to be mismatched from each other, thereby improving the deposition efficiency. Further, due to the arrangement structure, a dead space may be reduced when the deposition process is performed, and higher utilization may be obtained even in the deposition process by increasing the deposition thickness or applying the thick material. When a larger area is deposited by OLED deposition equipment, the tensile force may be increased. In this case, when using the unit holes pattern in which the arrangement position of the first surface hole and the arrangement position of the second surface hole are mismatched from each other, according to the second embodiment of the present invention, the tensile force is uniformly distributed. Accordingly, the OLED deposition uniformity may be ensured.

3. Third Embodiment

Hereinafter, another embodiment of the present invention will be described.

The present third embodiment may employ all features of a deposition mask described above with reference to the first embodiment and the third embodiment. However, in the following description, the structure having the feature of the third embodiment is independently realized for the illustrative purpose.

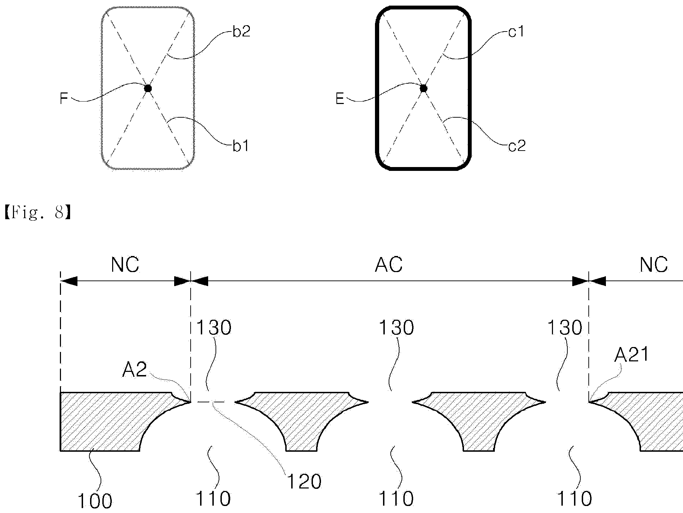

FIG. 8 is a cross-sectional view schematically illustrating the deposition mask including a plurality of unit holes of FIG. 2 according to a third embodiment of the present invention.

Referring to FIGS. 2 and 8, a deposition mask according to the third embodiment of the present invention includes a metal plate having a specific thickness and the metal plate may include a first surface and a second surface perpendicular to the thickness direction and opposite to each other. In this case, the metal plate includes a plurality of unit holes having a first surface hole 110 and a second surface hole 130 formed through the first surface and the second surface, respectively, to connect with each other through a boundary part 120 connected with each other through the first and second surface holes 110 and 130.

In particular, the unit hole may be realized in such a manner that the depth of the first surface hole formed in the thickness direction of the metal plate is different from the depth of the second surface hole formed in the thickness direction of the metal plate. In this case, on the basis of the outermost protruding points A1 to A21 of the boundary part 120 through which the first surface hole 110 and the second surface hole 130 connect with each other, an area having the second surface hole 130 and subject to the deposition process is referred to as "an active area (AC)". In addition, an area, which is not subject to the deposition process, is defined as a non-active area (NC), in which the area has no the second surface hole which is included in the outer portion of the outermost protruding points A1 to A21 of the boundary part 120 to which the first surface hole 110 and the second surface hole 130 connect with each other.

In other words, referring to FIGS. 2 and 8, the unit holes in the active area AC may be realized in the above illustrated structure such that the depth 'b' of the first surface hole 110 to the boundary part 120 is greater than the depth 'a' of the second surface hole 130 to the boundary part 120. In addition, as a whole, the unit holes may be realized such that the relation between the depth 'a' of the second surface hole and the whole thickness 'c' of the metal plate satisfies the range of 1: 3 to 30.

According to an embodiment of the present invention, when the unit holes in structures making difference in width and depth is realized, the depth 'a' of the second surface hole 130 serves as an important factor for adjusting the deposition thickness. As the depth 'a' of the second surface hole 130 is excessively increased, the depth of the second surface hole 130 may exceed the above-described thickness ratio range in the relation with the thickness 'c' of the whole base material. In this case, the variation in the thickness of an organic material may be increased, thereby causing a fatal problem of causing a dead space in which the deposition is not achieved. The dead space reduces the area of the organic material in the whole OLED to reduce the lifespan.

Therefore, according to the third embodiment of the present invention, the ratio between the depth 'a' of the second surface hole 130 and the thickness 'c' of the metal plate may satisfy the ratio of 1: (3.5 to 12.5) while satisfying the above-described range. More particularly, the ratio between the depth 'a' of the second surface hole 130 and the thickness 'c' of the metal plate may be realized to satisfy the ratio of 1: (4.5 to 10.5). According to an embodiment of the present invention, the thickness 'c' of the metal plate satisfying the above-described ratio range may be realized to be in the range of 10 $\mu$m to 50 $\mu$m. If the thickness of the metal plate is realized to be less than 10 $\mu$m, the twist degree of the base material is increased so the process control is difficult. If the thickness of the base material exceeds 50 $\mu$m, the dead space is increased in the subsequent deposition process, so that the fine pattern of the OLED may not be realized. In particular, the thickness 'c' of the above-described base material in the above range may be realized to satisfy the thickness in the range of 15 $\mu$m to 40 $\mu$m. Further, more preferably, the thickness of the base material may be realized to be in the range of 20 $\mu$m to 30 $\mu$m.

In addition, the depth 'a' of the second surface hole corresponding to the thickness 'c' of the metal plate may be preferably realized to satisfy the range of 0.1 $\mu$m to 7 $\mu$m. If the depth 'a' of the second surface hole is realized to be less than 0.1 $\mu$m, the hole may not be realized. If the depth 'a' of the second surface hole exceeds 7 $\mu$m, the OLED fine pattern may not be formed due to the dead space in the subsequent deposition process, and the area of the organic material may be reduced, so that the OLED lifespan may be reduced. In particular, the depth 'a' of the second surface hole may be realized to be in the range of 1 $\mu$m to 6 $\mu$m within the above range. More preferably, the depth 'a' of the second surface hole may be realized to be in the rage of 2 $\mu$m to 4.5 $\mu$m.

A slope angle of the inner surface of the first surface hole 110, into which a deposition material is introduced, may be taken into consideration to more improve the deposition efficiency, which is illustrated in FIG. 2.

Since a slope angle $\theta$, which is formed by connecting a specific point $A_1$ positioned at the outermost side of the boundary part 120 with a specific point $B_1$ positioned at the outermost side of the first surface hole 110 of the first surface, is used, the slope angle $\theta$ satisfies the above range to ensure the deposition uniformity. If the slope angle exceeds or goes beyond the range, the probability in which the dead space is increased, so that it is difficult to ensure the uniform deposition reliability. According to an embodiment of the present invention, as a preferred embodiment realized within the range of the inclination angle (θ), the inclination angle (θ) may be realized to satisfy the range of 30° to 60°, more preferably, the range of 32° to 38° or the range of the range of 52° to 58°.

According to an embodiment, the structure of the first surface hole connecting with the second surface hole by sharing the boundary surface between the first surface hole and the second surface hole is advantageous in the deposition efficiency when the structure of the first surface hole has the feature of reducing the width of each hole toward the central portion of the metal plate, More preferably, the inner surface of the second hole or the first hole may be realized in the structure having the curvature. The curvature structure may adjust the density of introducing the deposition material and may improve the deposition uniformity as compared with the structure of a simple slope.

In addition, according to an embodiment of the present invention, the width C of an opening in the one surface of the second surface hole, the width A of the boundary part, and the width B of the opening hole in the opposite surface of the first surface may have the ratio of B>C>A. This may adjust the density of introducing the deposition material and may improve the deposition uniformity. In addition, the difference (d=C-A) in length between the width 'C' of the opening in the one surface of the second surface hole and the width 'A' of the boundary part may be realized to satisfy the range of 0.2 $\mu$m to 14 $\mu$m.

In other words, the vertical distance d1, which is formed between a specific point C1 positioned at the outermost part of the one surface of the second surface hole and a specific point A1 positioned at the outermost part of the boundary part, may satisfy in the range of 0.1 $\mu$m to 7 $\mu$m. If the vertical distance d1 is less than 0.1 $\mu$m, the hole may not be realized. If the vertical distance d1 exceeds 7 $\mu$m, the OLED fine pattern may not be formed due to the dead space in the subsequent process, the area of the organic material may be reduced, thereby causing the OLED lifespan to be reduced. In addition, according to a preferred embodiment that is realized in the numeric range of the vertical distance d1, the vertical distance d1 may be realized in the range of 1 $\mu$m to 6 $\mu$m, and more particularly, may be realized in the range of 2 $\mu$m to 4.5 $\mu$m.

In addition, according to an embodiment of the present invention, the corner part of the opening in the one surface of the second surface hole (or first surface hole) may be realized in the structure having a curvature.

As illustrated in FIG. 5 or FIG. 6, when considering the horizontal sectional shape of the opening area exposed to a top surface of the second surface hole 110, that is, one surface of the base material, the horizontal sectional shape may be realized in a rectangular structure or a square structure. In this case, preferably, a rounding structure is realized at each corner part having a specific curvature.

If the diameter R of a virtual circle formed by extending the curvature of the rounded part of the corner part is realized in the range of 5 $\mu$m to 20 $\mu$m, the deposition area may be more widened. The shape of the hole part having an pointed corner may make it difficult to smoothly perform the deposition process and the dead space is essentially formed. The deposition efficiency in the rounding structure is increased. In particular, the highest deposition rate is represented and the uniform deposition may be realized at the curvature in the above numeric range. If the diameter is less than 5 $\mu$m, the deposition efficiency may not make a great difference from the structure having no curvature. If the diameter exceeds 20 $\mu$m, the deposition rage may be degraded. In particular, according to a preferred embodiment within the diameter R range, the diameter R may be realized in the range of 7 $\mu$m to 15 $\mu$m, and more particularly, in the range of 8 $\mu$m to 12 $\mu$m.

In particular, according to an embodiment of the present invention, the surface roughness Ra on the one surface or the opposite surface of the base material may be preferably realized to be at most 2 $\mu$m, which serves as one factor for improving the deposition quality of the organic material. If the surface roughness is increased, the resistance is made against the movement of the mounting material along the hole. If the surface roughness is realized to be at least 2 $\mu$m, the smooth deposition is difficult, thereby increasing the ratio in which the dead space is generated.

4. Fourth Embodiment

Hereinafter, a deposition mask according to another embodiment of the present invention is suggested. The technical feature according to the first embodiment to the third embodiment may be applied to the present fourth embodiment. However, in the following description, the feature according to the fourth embodiment will be independently realized for the illustrative purpose.

According to the fourth embodiment, a deposition mask includes a metal plate having a specific thickness and the metal plate may include a first surface and a second surface perpendicular to the thickness direction and opposite to each other. In this case, the metal plate includes a plurality of unit holes having a first surface hole 110 and a second surface hole 130 formed through the first surface and the second surface, respectively, to connect with each other through a boundary part 120 connected with each other through the first and second surface holes 110 and 130.

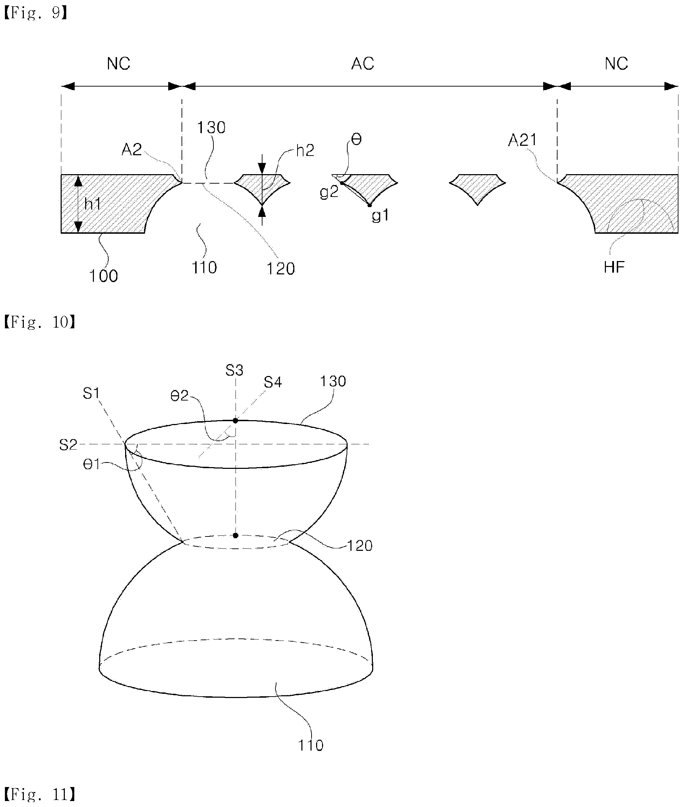

However, referring to FIG. 9, the structure of FIG. 9 has a difference from that of the third embodiment described with reference to FIG. 8 in that a metal plate thickness in an active area AC differs from a metal plate thickness of a non-active area NC in the structure of the deposition mask including the active area AC having a unit hole and the non-active area NC provided outside the active area AC.

In particular, referring to FIG. 9, according to the fourth embodiment, when taking into consideration the maximum thickness h1 of the metal plate in the active area having the unit hole and the maximum thickness h2 of the metal plate in the non-active area outside the active area, the maximum thickness h1 of the metal plate in the active area is realized with a value smaller than the maximum thickness H2 of the metal plate in the non-active area. In this case, the maximum thickness h1 of the metal plate in the active area is defined as the maximum value among thicknesses of longest protrusions (hereinafter, referred to as "a protrusion"; g1) of the metal plate protruding in the thickness direction of the metal plate.

In this case, the maximum thickness h2 of the metal plate in the non-active area may be made to satisfy $0.2h_1 < h_2 < 1.0h_1$ in the relation with the maximum thickness h1 of the metal plate in the active area. Further, the maximum thickness h2 may be realized to satisfy $0.2h_1 < h_2 < 0.9h_1$ included in the above range.

The maximum thickness h1 of the metal plate in the active area may be realized to be 20% to 100% of the maximum thickness h2 of the metal plate in the non-active area. Further, in the above range, the maximum thickness h1 may be formed to have the thickness of 25% to 85%, further, 30% to 60% of the maximum thickness h2. For example, when the maximum thickness h2 in the non-active area is 30 $\mu$m, the maximum thickness h1 of the metal plate in the active area may be realized in the range of 6 $\mu$m to 27 $\mu$m, 7.5 $\mu$m to 25.5 $\mu$m, or 9 $\mu$m to 18 $\mu$m.

The above numeric number range may increase the deposition efficiency by adjusting the slope (inclination angle) of the first surface hole. If the height of the active area is lowered, the deposition angle may be easily ensured and controlled, so that the high-resolution deposition mask may be realized.

FIG. 10 is a cross-sectional view schematically illustrating a unit hole in which the first surface hole and the second surface hole of FIG. 9 connect with each other. Referring to FIGS. 9 and 10, as described above, to ensure, especially, the deposition angle, an inclination angle of a line, which extends from one point of an opening of the first surface hole or the second surface hole provided in the surface of the metal plate to a predetermined point on the boundary part, may be taken into consideration. In this case, the slope realized from one point on a major axis of the opening to the boundary part may be realized to differ from the slope from one point on a minor axis to the boundary part.

In detail, a first inclination angle $\theta_1$ of a line extending from one point on a major axis of the opening of the first surface hole 110 or the second surface hole 130 exposed to the surface of the metal plate to a predetermined point on the boundary part 120 between the first surface hole and the second surface hole is realized to differ from a second inclination angle $\theta_2$ of a line extending from one point on the minor axis of the opening of the first surface hole or the second surface hole exposed to the surface of the metal plate to one point of the boundary part 120 between the first surface hole and the second surface hole. In other words, various slopes may be realized on the same inner surface of the first surface hole or the second surface hole. According to the present embodiment, especially, the first inclination angle $\theta_1$ is realized to be less than the second inclination angle $\theta_2$. In this case, the first inclination angle $\theta_1$ may be realized to be in the range of 20° to 80°. When various slope angles are realized in the same inner part of the second surface hole (or the first surface hole), the uniformity of the deposited member may be improved.

Further, in the structure according to the present fourth embodiment, a structure having the curvature may be formed at the protrusion g1 facing the pointed part of the active area described with reference to FIG. 9. If the curvature is realized at the protrusion g1 facing the pointed portion of the active area as described above, the deposition material, which is introduced through the first surface hole, may be efficiently dispersion and introduced into adjacent different areas. Accordingly, the deposition efficiency and the deposition uniformity may be improved. To this end, in the case of the curvature formed at the protrusion g1, the radius R of curvature is realized to become 0.5 $\mu$m or more. If the radius R of curvature is realized to become less than 0.5 $\mu$m, the dispersion efficiency may be degraded.

Additionally, in the structure according to the present fourth embodiment, a tensile-force adjusting pattern HF may be realized by etching the non-active area NC, which is illustrated in FIG. 9, in the thickness direction of the metal plate. The tensile-force adjusting pattern HF may be realized to have a groove pattern structure which is realized in the structure in which the metal plate is not penetrated.

The half etching area may be realized to have the thickness thinner than the thickness h1 of the metal plate. This is required to efficiently perform the deposition process by scattering the tensile force to be concentrated on the active area when the tensile force is applied to the deposition mask by equipment in the OLED deposition process, thereby allowing the deposition material to have uniformity.

In particular, the half etching area may be realized to have the thickness in the range of 10% to 100% of the thickness h1 of the metal plate. In other words, the thickness h3 of the half etching area may be realized to satisfy the relation of $0.1h1 < h3 < 1.0\ h1$ with respect to the thickness h1 of the metal plate in the non-active area. The thickness of the half etching area may be realized to be in the range of 20% to 80% or 30% to 70% of the thickness h1 of the metal plate within the thickness range of 10% to 100% of the thickness h1 of the metal plate.

For example, when the metal plate has the thickness of 30 $\mu$m, the thickness of the half etching area may be in the range of 3 $\mu$m to 27 $\mu$m (within the thickness range of 10% to 90% of the thickness h1 of the metal plate). Further, in order to produce the effect of scattering the tensile force by realizing the half etching area in a slimmer structure, the half etching area may be realized to be in the range of 6 $\mu$m to 24 $\mu$m which is 20% to 80% of the thickness of the metal plate, or to be in the range of 9$\mu$m to 21 $\mu$m which is 30% to 70% of the thickness of the metal plate.

FIG. 11 is a partial view illustrating a portion of the first surface in which the first surface hole of FIG. 10 is realized. Referring to FIGS. 10 and 11, in the structure according to the present fourth embodiment, a plurality of first surfaces are realized, in which the first surface is an opposite surface to the protrusion g1 facing the pointed portion of the active area described above. Accordingly, the deposition pitch may be reduced in the deposition process by realizing the first surfaces to have various heights. In other words, in the structure of FIG. 11, the heights at the points Z1, Z2, and Z3 may be realized to be different from each other.

5. Fifth Embodiment

Hereinafter, the structure of the deposition mask according to another embodiment of the present invention will be described. The structure according to the present fifth embodiment may have all features of the first to fourth embodiments. However, the following description will be made while focusing on an example of independently realizing the structure characterized according to the fifth embodiment.

The feature of the fifth embodiment will be described below by using the cross-sectional view illustrating the subject matter of the deposition mask according to the embodiment of the present invention.

In detail, similarly to the structure of FIG. 4, the deposition mask 100 according to an embodiment of the present invention includes a metal plate having a predetermined thickness and including a first surface and a second surface opposite to each other while being perpendicular to a thickness direction. The deposition mask 100 includes a plurality of unit holes having the first surface hole 110 and the second surface hole 130 connecting with each other while passing through the first surface and the second surface. In this case, the first surface hole 110 and the second surface hole 130 share a boundary part 120 through which the first and second surface holes 110 and 130 connect with each other. The unit holes are realized to be provided in the plural.

In this case, the unit hole may be realized in the deposition mask to have a roughness value equal to or less than the roughness value of the third roughness Ra3 which is the surface roughness of the first surface 112. In other words, the value of the first roughness Ra1 of the first inner surface or the second roughness Ra2 of the second inner surface 131, which is the inner surface of the second surface hole, may be formed with a value smaller than the value of the third roughness Ra3.

[Ra3 = (Ra2 or Ra1)]

Further, the second roughness Ra2 of the second inner surface 131 which is the inner surface of the second surface hole may be formed to have a value equal to or more than the first roughness Ra1 of the first inner surface 111 which is the inner surface of the first surface hole 110. [Ra2=Ra1].

If the roughness is formed in a reference amount or more on the surface of the present deposition mask realized with a metal material (metal mask), an influence is exerted on the straightness (line roughness of FIG. 7) of the unit hole, which is a hole for deposition, when the deposition mask is formed. Accordingly, an organic material is not smoothly deposited. In addition, when the organic material such as the OLED is deposited and then cleansed, the cleaning power for the organic material is degraded so that the lifespan of the deposition mask may be reduced.

According to the present embodiment, the arithmetic roughness average Ra1 of the first inner surface and the arithmetic roughness average Ra2 of the second inner surface may be realized to be 1.0 $\mu$m or less. If the roughness averages (Ra) of the first inner surface, the second inner surface and the first surface are realized to be in the range of 0.08 $\mu$m to 0.5 $\mu$m or 0.15 $\mu$m to 0.3 $\mu$m within the above range, the deposition efficiency may be realized with increased reliability.

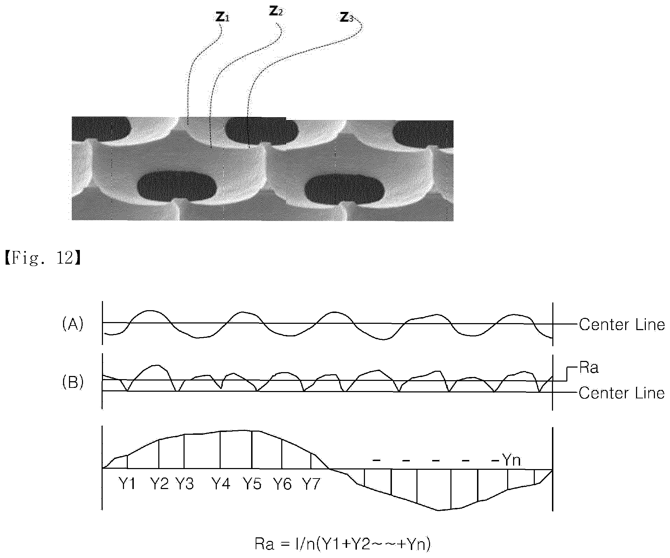

In this case, as illustrated in FIG. 12, the arithmetic roughness average Ra is expressed as Roughness Average (Ra), Center Line Average (CLA), Arith Metic Average (AA) and is obtained by calculating, with respect to the reference line, the height and the depth of the ridge and the valley of the surface within a reference line. In other words, as illustrated in the graph of FIG. 5, the degree of roughness is expressed with respect to the reference line (center line) serving as the reference of the surface for measuring the roughness and is calculated by an arithmetical average.

Further, in another aspect of the embodiment of the present invention, the value of Ten Point Height of Irregularities (Rz) of at least one of the first inner surface, the second inner surface, and the first surface of the deposition mask may be realized to be 3.0 $\mu$m or less. Further, the value of Ten Point Height of Irregularities (Rz) of at least one of the first inner surface, the second inner surface, and the first surface of the deposition mask is realized to be 2.5 or less, in detail, to be in the range of 1.5 to 2.5 while satisfying the above range, thereby improving the deposition efficiency with the increased reliability.

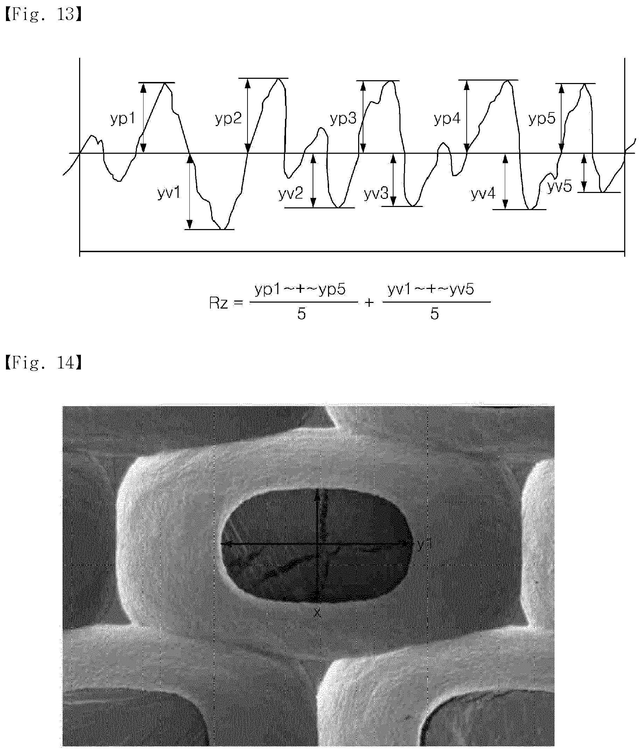

In this case, as illustrated in FIG. 13, the Ten Point Height of Irregularities (Rz) may refer to the surface roughness at 10 points around the reference line of the reference surface of a target surface to be measured in roughness.

Further, in the deposition mask according to the embodiment of the present invention, the line roughness (which is called the straightness of the unit hole) of an outer diameter of the unit hole described with reference to FIG. 2 may be realized to be 1. 5 $\mu$m. The line roughness, that is, the straightness of the outer diameter of the unit hole serves as an index representing the degree titled to any one side from the reference line (center line) formed by drawing a straight line extending from the central point of the outer diameter of the hole. The distance farthest from the center line is expressed by using the straightness.

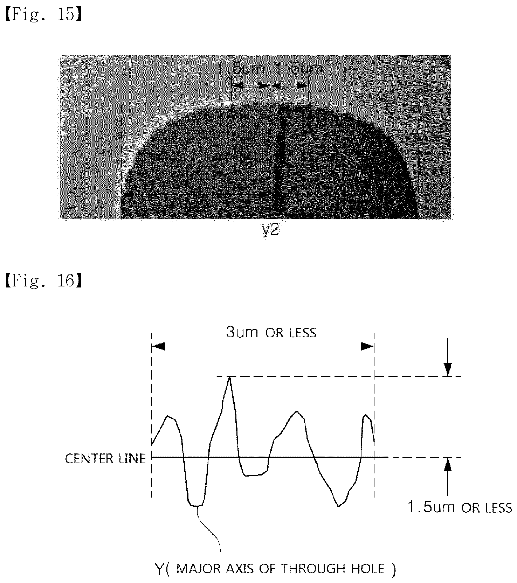

According to the embodiment of the present invention, measuring the straightness will be described with reference to FIGS. 14 to 16. FIGS. 14 and 15 illustrate an image of a real appearance of the first surface hole of FIG. 2. Referring to FIGS. 14 and 15, on the assumption that the minor axis and the major axis of the opening of the first surface hole are referred to as "x" and "y", respectively, the total length of the y axis, which is measured only with respect to the y axis serving as the major axis, may be divided in half, and the center of the y axis may be referred to as "y2". In this case, the roughness is measured along the circumference of the outer diameter of the opening while satisfying the range of the distance of 1.5 $\mu$m left or right from the center "y2", that is, the range of 3 $\mu$m in total. In this case, the measurement range is the range which does not exceed 3 $\mu$m. While satisfying the range of 3 $\mu$m, the straightness of the deposition mask according to the embodiment of the present invention may be realized to be 1.5 $\mu$m or less. In other words, the straightness may be realized to be 1.5 $\mu$m or less while satisfying the measurement range of 3 $\mu$m.

6. Sixth Embodiment

Hereafter, examples of a metal substrate used in manufacturing the deposition mask according to the first embodiment to the fifth embodiment described above will be described.

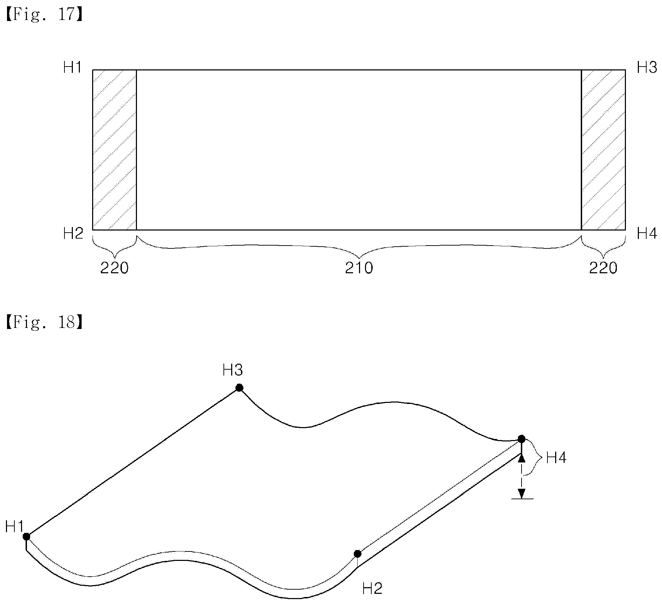

FIGS. 17 and 18 are schematic views illustrating the feature of the metal substrate according to an embodiment of the present invention.

Referring to FIGS. 17 and 18, the metal plate according to the embodiment of the present invention may be realized with a thickness sufficient to manufacture the deposition mask by etching a base metal plate having a predetermined thickness. In addition, the metal plate may be realized to minimize the local twist or the full twist.

To this end, as illustrated in FIG. 17, in the case of the metal plate according to the first embodiment of the present invention, a sample substrate 200 is extracted from the base metal plate having a predetermined thickness throughout the entire portion of the metal plate and is etched to realize an etching area 210 and a non-etching area 220. (Hereinafter, a substrate extracted from the base metal plate for the etching is referred to as "a sample substrate", and a substrate, which is extracted from the base substrate and not subject to the etching, is referred to as "a unit substrate".)

In this case, the base metal plate includes a first surface and a second surface perpendicular to the thickness direction and opposite to each other. In this case, the base metal plate includes a first surface and a second surface perpendicular to the thickness direction and opposite to each other. Regarding the base metal plate, a sample substrate 200 having the size of 30mm*180mm (width * length) is extracted from a specific point of the base metal plate and an etching process is performed with respect to the inner part of the sample substrate except for 10 mm (part 220) inward from both ends of the sample substrate 200 such that an etching area 210 is realized with the thickness corresponding to 2/3 to 1/2 of the thickness of the sample substrate 200. Thereafter, when the sample substrate is mounted on the horizontal target surface, the twist index (Hr) of the sample substrate subject to the etching satisfies the following relation.

Equation 1

$$Hr = \{(H1 - Ha)^2 + (H2 - Ha)^2 + (H3 - Ha)^2 + (H4 - Ha)^2\}^{1/2}$$

Equation 2

$$Ha = (H1 + H2 + H3 + H4)/4$$

(Ha refers to the average of distances H1, H2, H3, and H4 from a horizontal target surface to four corners of the etched sample substrate.)

In detail, the feature of the metal substrate according to the embodiment of the present invention will be described below with reference to FIGS. 1, 17, and 18.

In general, as illustrated in FIG. 1, the deposition mask manufactured by using the metal substrate according to the embodiment of the present invention serves as a mask structure to realize the organic layer of the OLED. The deposition mask is to realize a deposition target T on a base G such as deposition source glass for providing a deposition material. In this case, the deposition mask (M) 100 is realized in the structure having a plurality of unit holes. In general, to improve the deposition uniformity in the OLED deposition, the deposition mask has to be maintained in a uniform state during the deposition process.

However, basically, in the case that the metal plate is etched to manufacture the deposition mask, the thickness of the metal plate is significantly reduced. If a plurality of deposition holes are realized in the metal plate having the thickness significantly reduced, the manufactured deposition mask is easily twisted. Accordingly, in the arrangement structure as illustrated in FIG. 1, the deposition uniformity may not be ensured.

Accordingly, the embodiment of the present invention may provide a metal substrate capable minimizing the twist caused by the metal plate or caused when the metal plate is etched.

According to the manufacturing process of the metal substrate of the present invention, a sample substrate having the size of 30 mm x 180 mm is extracted from a base substrate.

Thereafter, the sample substrate is subject to 1/2 to 2/3 etching, except for 10 mm from both sides of a major axis of the sample substrate having the length of 180 mm. Thereafter, when the sample substrate subject to the etching is disposed on a surface surface having an ensured flatness, that is, a target, such as a surface plate, the heights H1, H2, H3, and H4 of the four corners of the sample substrate, which are spaced apart from the reference surface which is the horizontal target surface of the surface plate, are measured.

In this case, when the heights H1, H2, H3, and H4 of the four corners of the sample substrate, which are spaced apart from the reference surface are equal to or greater than '0', the sample substrate is determined as being twisted. Such a twist degree is represented by an index (Hr) expressed in an exponential form as expressed in Equation 1.

Accordingly, as the twist index Hr of the sample substrate is increased, the twist degree of the substrate is increased. According to the embodiment of the present invention, when comparing in the twist index between a non-etching sample substrate (hereinafter, referred to as "unit substrate") extracted in an equal size of 30mm × 180mm from a predetermined point of the base metal plate and the sample substrate subject to the etching, the twist index of the sample substrate subject to the etching is greater than the twist index of the non-etching sample substrate.

In other words, the non-etching sample substrate (unit substrate) extracted in the size of 30mm × 180mm (width × length) from the predetermined point of the base metal plate, which has been described above, is mounted on the horizontal target surface in such a manner that the twist index Hr (T1) extracted through Equations 1 and 2 for four corners of the substrate T1 is equal to or less than the twist index Hr (T2) of the sample substrate T2 extracted from the base metal plate and subject to the etching. This may be expressed in following equation.

```
Equation 3

Hr(T1) = Hr(T2)
```

In particular, according to the embodiment of the present invention, the twist index of the sample substrate may be realized to be equal to or less than 10. Accordingly, if the thickness of the base substrate is 20 $\mu$m, and if the sample substrate is extracted and subject to the etching, the thickness of the sample substrate subject to the etching is realized to be 10 $\mu$m or less at four corners of the sample substrate.

In other words, the twist index of the sample substrate subject to the etching may be realized to be 10 or less, preferably, to be a value in the range of 0.2 to 7 or 0.5 to 5. If the twist index of the sample substrate is realized to be 10 or less, the twist phenomenon may be reduced when manufacturing the final deposition mask. In addition, the lateral deviation of the OLED is reduced in the OLED deposition, thereby improving the deposition uniformity.

According to the embodiment of the present invention, in order to realize the twist index of the sample substrate to be 10 or less, a cooling process and a rolling process may be performed when the metal pate is realized from a base material. Once, after the cooling process is performed with respect to the base material at the temperature of 10 °C to 20 °C, the rolling process may be performed. The rolling process is performed to realize the metal plate having a desired thickness. In this case, the rolling degree is an important factor. In addition, the reduction ratio may be realized to 2/3 to 1/5 with respect to a unit volume (1mm$^3$) at a predetermined point of the base material.

FIG. 18 is a view illustrating a twist index when the sample substrate is extracted from the metal plate 200 according to the embodiment of the present invention and etched. As illustrated in the drawing, the four corners of the sample substrate is spaced apart from the horizontal target surface ST and at least one of the distances H1 to H4 from the horizontal target surface has a value different from remaining distances. In addition, the distances H1 and H2 or the distances H3 and H4 of adjacent potions in a minor axis of the sample substrate may be different from each other.

In the case of the metal substrate according to the embodiment of the present invention, the deposition mask may be realized to include a plurality of unit holes having a first surface hole and a second surface hole which are formed through the first surface and the second surface of the etching area of the metal plate to connect with each other. In particular, the deposition mask realized in such a manner may be remarkably reduced in twist, so that the deposition reliability may be realized.

Although a preferred embodiment of the present invention has been described for illustrative purposes, those skilled in the art will appreciate that various modifications, additions and substitutions are possible, without departing from the scope and spirit of the invention as disclosed in the accompanying claims.

**Claims**

1. A deposition mask comprising:

   a metal plate comprising a first surface and a second surface opposite to the first surface,
   wherein the metal plate comprises a plurality of unit hole,
   wherein the unit hole comprises a first surface hole forming in the first surface, a second surface hole forming in the second surface, and a boundary part through which the first surface hole and the second surface hole communicate with each other,
   wherein a width of the first surface hole is greater than a width of the second surface hole,
   wherein a first incline angle formed by a virtual line connecting a point in the long axis direction of the opening of the first surface hole exposed on the surface of the metal plate and one point of the boundary part, and the long axis direction of the first surface hole is different with a second incline angle formed by a virtual line connecting a point in the short axis direction of the opening of the first surface hole exposed on the surface of the metal plate and one point of the boundary part, and the short axis direction of the first surface hole.

2. A deposition mask comprising:

   a metal plate comprising a first surface and a second surface opposite to the first surface,
   wherein the metal plate comprises a plurality of unit hole,
   wherein the unit hole comprises a first surface hole forming in the first surface, a second surface hole forming in the second surface, and a boundary part through which the first surface hole and the second surface hole communicate with each other,
   wherein a width of the first surface hole is greater than a width of the second surface hole,
   wherein a first incline angle formed by a virtual line connecting a point in the long axis direction of the opening of the second surface hole exposed on the surface of the metal plate and one point of the boundary part, and the long axis direction of the second surface hole is different with a second incline angle formed by a virtual line connecting a point in the short axis direction of the opening of the second surface hole exposed on the surface of the metal plate and one point of the boundary part, and the short axis direction of the second surface hole.

3. The deposition mask of claim 1 or 2, wherein the first incline angle is smaller than the second incline angle.

4. The deposition mask of claim 1 or 2, wherein the first incline angle is 20 to 80 degrees.

5. The deposition mask of claim 1 or 2, wherein a ratio of the depth of the second surface hole to the thickness of the metal plate is 1: (3 to 30).

6. The deposition mask of claim 1 or 2, wherein a depth of the second surface hole is 0.1 $\mu$m to 7 $\mu$m.

7. The deposition mask of claim 1 or 2, wherein a difference (C-A) between the width of the second surface hole and the width of the boundary part is 0.2 $\mu$m to 14 $\mu$m.

8. The deposition mask of claim 1 or 2, wherein an edge of the first surface hole or the edge of the second surface hole has a curvature having a radius of curvature of 2.5 $\mu$m to 10 $\mu$m.

【Fig. 1】

【Fig. 2】

【Fig. 3】

【Fig. 4】

【Fig. 5】

【Fig. 6】

【Fig. 7】

b2

F

b1

c1

E

c2

【Fig. 8】

NC

AC

NC

130

A2

130

130

A21

100

110

120

110

110

【Fig. 9】

【Fig. 10】

【Fig. 11】

$Z_1$  $Z_2$  $Z_3$

【Fig. 12】

(A) — Center Line

(B) — Ra — Center Line

Y1 Y2 Y3  Y4 Y5 Y6 Y7  − − − − −Yn

$$Ra = I/n(Y1+Y2 \sim \sim +Yn)$$

【Fig. 13】

$$Rz = \frac{yp1 \sim + \sim yp5}{5} + \frac{yv1 \sim + \sim yv5}{5}$$

【Fig. 14】

【Fig. 15】

【Fig. 16】

【Fig. 17】

H1                                                     H3

H2                                                     H4

220                           210                           220

【Fig. 18】

H3

H4

H1

H2

Europäisches
Patentamt

European
Patent Office

Office européen
des brevets

# EUROPEAN SEARCH REPORT

Application Number

**EP 21 21 4316**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2013/166951 A1 (KUN SHAN POWER STENCIL CO LTD [CN]) 14 November 2013 (2013-11-14) | 1,2 | INV. H01L51/00 C23C14/04 C23C14/12 C23C16/04 C23F1/02 |
| A | * claims 1-15; figures 1-4 * | 3-8 | |
| X | JP 5 641462 B1 (DAINIPPON PRINTING CO LTD) 17 December 2014 (2014-12-17) | 1,2 | |
| A | * claims 1-15; figure 21 * | 3-8 | |
| X | CN 104 164 647 A (KUNSHAN POWER STENCIL CO LTD) 26 November 2014 (2014-11-26) | 1,2 | |
| A | * claims 1-10; figure 1 * | 3-8 | |

TECHNICAL FIELDS
SEARCHED (IPC)

H01L
C23C
C23F

The present search report has been drawn up for all claims

| Place of search | Date of completion of the search | Examiner |
|---|---|---|
| The Hague | 25 March 2022 | Battistig, Marcello |

EPO FORM 1503 03.82 (P04C01)

## ANNEX TO THE EUROPEAN SEARCH REPORT
## ON EUROPEAN PATENT APPLICATION NO.

EP 21 21 4316

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2022

| Patent document cited in search report | | Publication date | Patent family member(s) | | Publication date |
|---|---|---|---|---|---|
| WO 2013166951 | A1 | 14-11-2013 | CN | 103388121 A | 13-11-2013 |
| | | | JP | 5969114 B2 | 10-08-2016 |
| | | | JP | 2015518524 A | 02-07-2015 |
| | | | KR | 20150021914 A | 03-03-2015 |
| | | | TW | 201347267 A | 16-11-2013 |
| | | | WO | 2013166951 A1 | 14-11-2013 |
| JP 5641462 | B1 | 17-12-2014 | CN | 106460149 A | 22-02-2017 |
| | | | CN | 111004996 A | 14-04-2020 |
| | | | DE | 202015009768 U1 | 10-02-2020 |
| | | | EP | 3144410 A1 | 22-03-2017 |
| | | | EP | 3604608 A1 | 05-02-2020 |
| | | | JP | 5641462 B1 | 17-12-2014 |
| | | | JP | 2015214741 A | 03-12-2015 |
| | | | KR | 20160143770 A | 14-12-2016 |
| | | | KR | 20170081731 A | 12-07-2017 |
| | | | US | 2017141315 A1 | 18-05-2017 |
| | | | US | 2020185607 A1 | 11-06-2020 |
| | | | WO | 2015174269 A1 | 19-11-2015 |
| CN 104164647 | A | 26-11-2014 | NONE | | |

EPO FORM P0459

For more details about this annex : see Official Journal of the European Patent Office, No. 12/82